# FASCICULE DE BREVET EUROPEEN

(11) **EP 3 323 151 B1**
(45) Date de publication et mention de la délivrance du brevet: **25.11.2026**
(21) Numéro de dépôt: 16747543.3
(22) Date de dépôt: 13.07.2016
(51) Int. Cl.: H10H 20/01, H10F 71/00

(54) **DISPOSITIF OPTOELECTRONIQUE À ÉLÉMENTS SEMICONDUCTEURS TRIDIMENSIONNELS ET SON PROCÉDÉ DE FABRICATION**
OPTOELEKTRONISCHE VORRICHTUNG MIT DREI-DIMENSIONALEN HALBLEITER-ELEMENTEN UND DEREN HERSTELLUNGSVERFAHREN
OPTOELECTRONIC DEVICE WITH TRI-DIMENSIONAL SEMICONDUCTING ELEMENTS AND MANUFACTURE THEREOF

(30) Priorité: 16.07.2015 FR 1556744
(43) Date de publication de la demande: 23.05.2018
(73) Titulaire: Aledia, 38800 Champagnier (FR); Commissariat à l'Energie Atomique et aux Energies Alternatives, 75015 Paris (FR); Université Grenoble Alpes, 38400 Saint Martin d'Hères (FR)
(72) Inventeur: GILET, Philippe, 38470 Teche (FR); DUSSAIGNE, Amélie, 38260 Saint Hilaire De La Cote (FR); SALOMON, Damien, 38000 Grenoble (FR); EYMERY, Joel, 38360 Sassenage (FR); DURAND, Christophe, 38950 Quaix-en-Chartreuse (FR)
(74) Mandataire: Cabinet Beaumont
(86) Numéro de dépôt international: PCT/FR2016/051818
(87) Numéro de publication internationale: WO 2017/009583

(56) Documents cités:
- EP-A1- 2 509 119
- WO-A1-2014/102512
- FR-A1- 3 000 613
- W. BERGBAUER ET AL: "N-face GaN nanorods: Continuous-flux MOVPE growth and morphological properties", JOURNAL OF CRYSTAL GROWTH, vol. 315, no. 1, 15 January 2011 (2011-01-15), pages 164 - 167, XP055003815, ISSN: 0022-0248, DOI: 10.1016/j.jcrysgro.2010.07.067
- BOUGRIOUA ET AL: "Growth of freestanding GaN using pillar-epitaxial lateral overgrowth from GaN nanocolumns", JOURNAL OF CRYSTAL GROWTH, ELSEVIER, AMSTERDAM, NL, vol. 309, no. 2, 15 November 2007 (2007-11-15), pages 113 - 120, XP022346928, ISSN: 0022-0248, DOI: 10.1016/J.JCRYSGRO.2007.09.030

## Description

### Domaine

La présente description concerne de façon générale les dispositifs optoélectroniques comprenant des éléments semiconducteurs tridimensionnels, par exemple des microfils, des nanofils, des éléments coniques ou des éléments tronconiques, et leurs procédés de fabrication.

Par dispositifs optoélectroniques, on entend des dispositifs adaptés à effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés à des applications photovoltaïques.

### Exposé de l'art antérieur

On s'intéresse plus particulièrement ici à l'amélioration des dispositifs optoélectroniques de types radiaux, comprenant une coque, contenant une zone active, formée à la périphérie de chaque élément semiconducteur tridimensionnel. La zone active de la coque est la zone de laquelle est émise la majorité du rayonnement électromagnétique fourni par la coque ou est captée la majorité du rayonnement électromagnétique reçu par la coque.

Les éléments semiconducteurs tridimensionnels considérés ici comprennent un matériau semiconducteur comportant majoritairement un élément du groupe III et un élément du groupe V (par exemple du nitrure de gallium GaN), appelé par la suite composé III-V. De tels dispositifs sont par exemple décrits dans la demande de brevet WO2014/102514.

Le document EP2509119 A1 divulgue une méthode connue pour la fabrication de telles structures.

Un procédé de fabrication d'un dispositif optoélectronique comprenant des éléments semiconducteurs de taille nanométrique ou micrométrique comprend généralement la croissance des éléments semiconducteurs et la croissance d'une coque recouvrant chaque élément semiconducteur. Le dispositif optoélectronique peut être réalisé dans un réacteur. Le procédé comprend, de façon générale, l'apport dans le réacteur de gaz précurseurs du composé III-V dans des proportions qui favorisent la croissance de chaque élément semiconducteur de façon privilégiée selon un axe, l'arrêt de la croissance des éléments semiconducteurs, et la modification des proportions des gaz précurseurs pour favoriser la formation de la première couche semiconductrice de la coque qui recouvre la périphérie de l'élément semiconducteur.

Chaque élément semiconducteur comprend essentiellement un empilement de plans cristallographiques perpendiculaires à la direction de croissance de l'élément semiconducteur et la coque comprend notamment un empilement de plans cristallographiques sur les faces latérales de l'élément semiconducteur.

Un inconvénient est que les faces latérales de l'élément semiconducteur sur lesquelles est formée la première couche semiconductrice de la coque correspondent aux bords des plans cristallographiques de l'élément semiconducteur et peuvent être irrégulières. Ceci peut entraîner la formation de défauts dans la première couche semiconductrice de la coque. Un autre inconvénient est que la croissance des éléments semiconducteurs est interrompue avant le début de la croissance des coques. Il peut alors être observé une accumulation d'impuretés, présentes dans le réacteur, sur les faces latérales de l'élément semiconducteur, ce qui peut entraîner la formation de défauts dans la coque. Ces défauts peuvent entraîner une diminution du rendement de conversion de la zone active.

### Résumé

Ainsi, un objet d'un mode de réalisation est de pallier au moins en partie les inconvénients des procédés de fabrication de dispositifs optoélectroniques comprenant des éléments semiconducteurs de taille micrométrique ou nanométrique, notamment des microfils ou des nanofils semiconducteurs, décrits précédemment et de leurs procédés de fabrication.

Un autre objet d'un mode de réalisation est de réduire le nombre de défauts dans la coque.

Un autre objet d'un mode de réalisation est de réduire l'encombrement latéral de la coque.

Un autre objet d'un mode de réalisation est de réduire la durée du procédé de fabrication des éléments semiconducteurs et des coques.

Un autre objet d'un mode de réalisation est que les dispositifs optoélectroniques à éléments semiconducteurs de taille nanométrique ou micrométrique puissent être fabriqués à une échelle industrielle et à bas coût.

Ainsi, un mode de réalisation prévoit un procédé de fabrication d'un dispositif optoélectronique comprenant des éléments semiconducteurs filaires, coniques ou tronconiques comportant majoritairement un composé III-V, chaque élément semiconducteur s'étendant selon un axe et comprenant une portion dont les faces latérales sont recouvertes d'une coque comprenant au moins une zone active, dans lequel l'élément du groupe V est l'azote, dans lequel les portions sont réalisées par croissance continue dans un réacteur et dans lequel la température dans le réacteur varie, au cours de la croissance continue des portions, sans interruption d'une première valeur de température qui favorise la croissance de premiers plans cristallographiques perpendiculaires audit axe, à une deuxième valeur de température, inférieure strictement à la première valeur de température, qui favorise la croissance de deuxièmes plans cristallographiques parallèles audit axe.

Selon l'invention, la première valeur de température est supérieure à 1000°C et la deuxième valeur de température est inférieure à 950°C.

Selon un mode de réalisation, la deuxième valeur de température est inférieure à 750°C.

Selon un mode de réalisation, un gaz précurseur de l'élément du groupe V et un gaz précurseur de l'élément du groupe III sont injectés dans le réacteur et le rapport entre le flux du gaz précurseur de l'élément du groupe V et le flux du gaz précurseur de l'élément du groupe III, appelé rapport V/III, varie d'une première valeur de rapport V/III à une deuxième valeur de rapport V/III supérieure strictement à la première valeur de rapport V/III.

Selon un mode de réalisation, la première valeur de rapport V/III est inférieure à 300, de préférence inférieure à 200, et la deuxième valeur de rapport V/III est supérieure à 500, de préférence supérieure à 1000.

Selon un mode de réalisation, la pression dans le réacteur est amenée, au cours de la croissance continue des portions, d'une première valeur de pression à une deuxième valeur de pression inférieure strictement à la première valeur de pression.

Selon un mode de réalisation, la première valeur de pression est supérieure à 53 kPa, de préférence supérieure à 67 kPa, et la deuxième valeur de pression est inférieure à 40 kPa, de préférence inférieure à 27 kPa.

Selon un mode de réalisation, du dihydrogène et du diazote sont injectés dans le réacteur et le rapport entre le flux de dihydrogène et le flux de diazote, appelé rapport H₂/N₂, varie d'une première valeur de rapport H₂/N₂ à une deuxième valeur de rapport H₂/N₂ supérieure strictement à la première valeur de rapport H₂/N₂.

Selon un mode de réalisation, la première valeur de rapport H₂/N₂ est inférieure à 40/60, de préférence inférieure à 30/70, et la deuxième valeur de rapport H₂/N₂ est supérieure à 60/40, de préférence supérieure à 70/30.

Selon un mode de réalisation, les zones actives sont les zones depuis lesquelles est émise la majorité du rayonnement fourni par le dispositif optoélectronique ou dans lesquelles est capturée la majorité du rayonnement reçu par le dispositif optoélectronique.

Selon un mode de réalisation, le composé III-V est un composé III-N choisi parmi le groupe comprenant le nitrure de gallium, le nitrure d'aluminium, le nitrure d'indium, le nitrure de gallium et d'indium, le nitrure de gallium et d'aluminium, le nitrure d'aluminium et d'indium et le nitrure de gallium, d'aluminium et d'indium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un dispositif optoélectronique à microfils ou nanofils ;
la figure 2 est une vue agrandie, partielle et schématique, d'une partie du dispositif optoélectronique de la figure 1 ;
la figure 3 représente, de façon schématique, l'empilement des plans cristallographiques à l'interface entre l'élément semiconducteur et la coque du dispositif optoélectronique de la figure 2 ;
la figure 4 est une vue analogue à la figure 2 d'un mode de réalisation d'un dispositif optoélectronique ;
la figure 5 représente, de façon très schématique, l'empilement des plans cristallographiques de croissance de l'élément semiconducteur du dispositif optoélectronique de la figure 4 ;
les figures 6A à 6D sont des coupes, partielles et schématiques, des structures obtenues à des étapes successives d'un mode de réalisation d'un procédé de fabrication du dispositif optoélectronique de la figure 4 ; et
les figures 7 à 10 sont des vues en coupe, partielles et schématiques, d'autres modes de réalisation de dispositifs optoélectroniques.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de polarisation du dispositif optoélectronique sont bien connus et ne sont pas décrits. Dans la suite de la description, sauf indication contraire, les termes "sensiblement", "environ" et "de l'ordre de" signifient "à 10 % près".

La présente description concerne des dispositifs optoélectroniques à éléments tridimensionnels, par exemple des microfils, des nanofils, des éléments coniques ou des éléments tronconiques. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil", "nanofil", "élément conique" ou "élément tronconique" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Dans la suite de la description, des modes de réalisation vont être décrits dans le cas d'un dispositif optoélectronique à diodes électroluminescentes. Toutefois, il est clair que ces modes de réalisation peuvent concerner d'autres applications, notamment des dispositifs dédiés à la détection ou la mesure d'un rayonnement électromagnétique ou des dispositifs dédiés aux applications photovoltaïques.

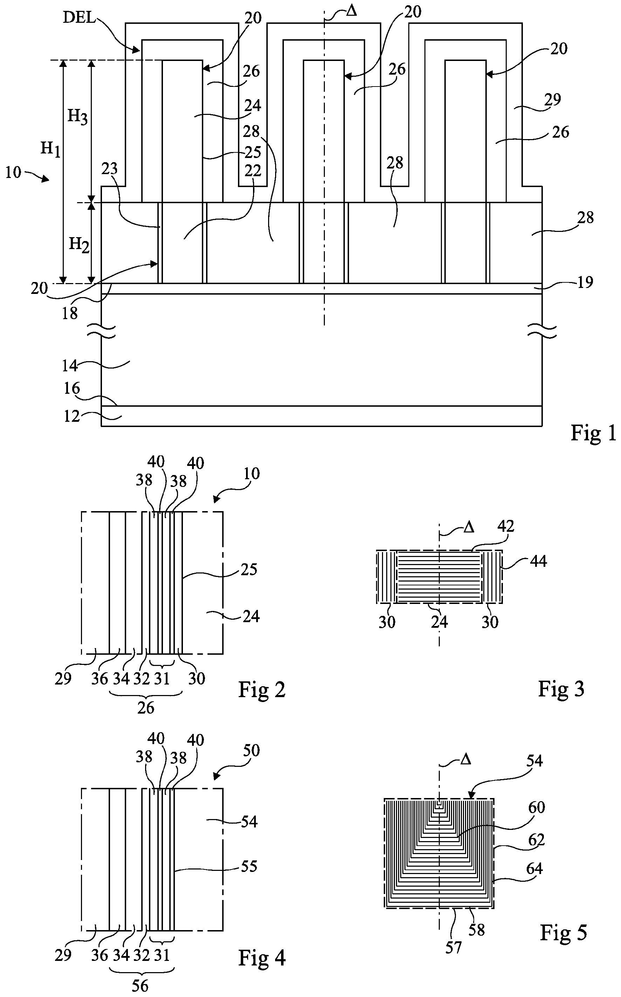

La figure 1 est une coupe, partielle et schématique, d'un dispositif optoélectronique 10 réalisé à partir de fils tels que décrits précédemment et adapté à l'émission d'un rayonnement électromagnétique.

Le dispositif 10 comprend, du bas vers le haut en figure 1 :
une première électrode de polarisation 12 ;
un substrat 14, par exemple semiconducteur, comprenant des faces parallèles 16 et 18, la face 16 étant au contact de l'électrode 12 et la face 18 étant traitée de façon à favoriser la croissance de fils de façon organisée, notamment de l'une des façons décrites précédemment. Ce traitement est représenté de façon schématique en figure 1 par une région 19 en surface du substrat 14 ;
des fils 20 d'axe Δ (trois fils étant représentés), de hauteur H₁, chaque fil comprenant une portion inférieure 22 de hauteur H₂, en contact avec la face 18, et une portion supérieure 24 de hauteur H₃ ;
une couche passivante 23 recouvrant la périphérie de chaque portion inférieure 22 ;
une coque 26 recouvrant chaque portion supérieure 24 ;
des portions isolantes 28 recouvrant la face 18 entre les fils 20 sur au moins la hauteur H₂ ; et
une couche de seconde électrode 29 recouvrant les coques 26 et les portions isolantes 28.

Chaque fil 20 est en un matériau semiconducteur comprenant majoritairement un composé III-V, par exemple du GaN.

L'ensemble formé par chaque fil 20 et la coque 26 associée constitue une diode électroluminescente DEL. La coque 26 comprend notamment une zone active qui est la couche depuis laquelle est émise la majorité du rayonnement électromagnétique fourni par la diode électroluminescente DEL. Les diodes électroluminescentes DEL peuvent être connectées en parallèle et former un ensemble de diodes électroluminescentes. L'ensemble peut comprendre de quelques diodes électroluminescentes DEL à un millier de diodes électroluminescentes.

La figure 2 est une vue agrandie de la coque 26. La coque 26 peut comprendre un empilement de plusieurs couches semiconductrices comprenant notamment :
un couche intercalaire 30, par exemple en GaN, recouvrant la portion supérieure 24 du fil 20 ;
une zone active 31 recouvrant la couche intercalaire 30 ;
éventuellement, une couche barrière 32 recouvrant la zone active 31 ;
une couche intermédiaire 34 de type de conductivité opposé à la portion inférieure 22 du fil 20 recouvrant la couche barrière 32 ; et
une couche de liaison 36 recouvrant la couche intermédiaire 34 et recouverte par l'électrode 29.

La couche intercalaire 30 est, de préférence, une couche du même matériau semiconducteur que la portion supérieure 24 du fil 20 ou d'un alliage de type GaInN ou AlGaN ou AlGaInN. La couche intercalaire 30 est prévue pour fournir une surface ayant des propriétés convenables pour la croissance de la zone active 31. L'épaisseur de la couche intercalaire 30 peut être de l'ordre de 5 nm à 5 µm, de préférence de 10 nm à 2000 nm.

La zone active 31 est la zone depuis laquelle est émise la majorité du rayonnement fourni par la diode électroluminescente DEL. Selon un exemple, la zone active 31 peut comporter des moyens de confinement tels que des puits quantiques multiples. Elle est, par exemple, constituée d'une alternance de couches de GaN 38 et de InGaN 40, deux couches 38 de GaN et deux couches 40 de InGaN étant représentées à titre d'exemple en figure 2. Les couches 38 de GaN peuvent être dopées, par exemple de type N ou P, ou non dopées. Selon un autre exemple, la zone active 31 peut comprendre un puit quantique unique comprenant une seule couche d'InGaN, par exemple d'épaisseur supérieure à 10 nm entre deux couches de GaN.

Selon un exemple de procédé de fabrication du dispositif optoélectronique 10, la portion supérieure 24 de chaque fil 20 peut être réalisée dans un réacteur par dépôt chimique en phase vapeur organométallique (MOCVD, acronyme anglais pour Metal-Organic Chemical Vapor Deposition). Les conditions de croissance dans le réacteur sont adaptées pour favoriser la croissance privilégiée de chaque fil 20 selon son axe Δ. Ceci signifie que la vitesse de croissance du fil 20 selon l'axe Δ est largement supérieure, de préférence d'au moins un ordre de grandeur, à la vitesse de croissance du fil 20 selon une direction perpendiculaire à l'axe Δ. A titre d'exemple, le procédé de croissance des fils 20 peut comprendre l'injection dans un réacteur d'un précurseur d'un élément du groupe III et d'un précurseur d'un élément du groupe V.

Une fois que la portion supérieure 24 de chaque fil 20 est réalisée, les flux des gaz précurseurs de l'élément du groupe III et de l'élément du groupe V sont interrompus. Le réacteur est alors à nouveau alimenté en gaz précurseurs de l'élément du groupe III et de l'élément du groupe V avec des flux adaptés pour favoriser une croissance du composé III-V notamment sur les faces latérales 25 de la portion supérieure 24 pour former la couche intercalaire 30 de la coque 26. Ceci signifie que la vitesse de croissance du composé III-V selon une direction perpendiculaire à l'axe Δ est supérieure ou égale à la vitesse de croissance du composé III-V selon une direction parallèle à l'axe Δ.

La figure 3 représente une vue en coupe agrandie de l'interface entre la portion supérieure 24 du fil 20 et la couche intercalaire 30 dans le cas où une croissance MOCVD a été mise en oeuvre. Lors de la croissance MOCVD, les espèces qui arrivent à la surface se disposent et se lient entre elles afin de former le matériau souhaité. Les conditions de croissance sont adaptées pour privilégier une croissance plan atomique par plan atomique, c'est-à-dire que préférentiellement, les espèces qui arrivent à la surface vont « terminer le plan » ou combler les « trous » du plan avant de commencer le plan cristallin suivant. On parle alors de croissance 2D. En figure 3, on a représenté, de façon très schématique, des plans cristallographiques de croissance 42 de la portion supérieure 24 du fil 20 et des plans cristallographiques de croissance 44 de la couche intercalaire 30 de la coque 26. Dans la portion 24, les plans de croissance sont perpendiculaires à l'axe Δ et dans la couche intercalaire 30, les plans de croissance 30 sont parallèles à l'axe Δ.

Un inconvénient est que les plans cristallographiques de croissance 44 sont formés sur les bords des plans cristallographiques de croissance 42. Ceci peut entraîner l'apparition de défauts dans la couche intercalaire 30. Un autre inconvénient est que, à la fin de la croissance de la portion supérieure 24, les flux des gaz précurseurs de l'élément du groupe III et de l'élément du groupe V sont momentanément interrompus. Pendant la durée d'interruption des gaz précurseurs, une accumulation d'impuretés peut être observée sur les faces latérales de la portion supérieure 24 du fil 20. Ceci peut également entraîner l'apparition de défauts dans la couche intercalaire 30. Il est alors nécessaire que la couche intercalaire 30 soit suffisamment épaisse pour empêcher la propagation des défauts jusqu'à la zone active 31, ce qui entraînerait une diminution du rendement quantique de la zone active 31.

La figure 4 est une vue analogue à la figure 2 d'un mode de réalisation d'un dispositif optoélectronique 50. Le dispositif optoélectronique 50 comprend l'ensemble des éléments du dispositif optoélectronique 10 représenté en figure 1 à la différence que la portion supérieure 24 de chaque fil 20 est remplacée par une portion supérieure 54 monobloc et que la coque 26 est remplacée par une coque 56. La coque 56 comprend tous les éléments de la coque 26 à la différence que la couche intercalaire 30 n'est pas présente. La portion supérieure 54 a sensiblement la même composition que la portion supérieure 24. Toutefois, la face latérale 55 de la portion supérieure 54 a des propriétés cristallographiques adaptées à la croissance de la zone active 31. La composition de la portion supérieure 54 est sensiblement uniforme. De préférence, la composition de la portion supérieure 54 est uniforme.

Même si la largeur, mesurée selon une direction perpendiculaire à l'axe Δ, de la portion supérieure 54 peut être supérieure à la largeur de la portion supérieure 24, la largeur totale, mesurée selon une direction perpendiculaire à l'axe Δ, de l'ensemble coque 56 - portion supérieure 54 peut, de façon avantageuse, être inférieure à la largeur de l'ensemble coque 26 - portion supérieure 24. La densité de diodes électroluminescentes du dispositif optoélectronique 50 peut alors être augmentée par rapport au dispositif optoélectronique 10 et la puissance lumineuse totale émise par le dispositif optoélectronique 50 peut être augmentée par rapport au dispositif optoélectronique 10.

La figure 5 est une vue analogue à la figure 3 de la portion supérieure 54 dans laquelle il a été représenté, de façon schématique, l'orientation cristalline du matériau au cours de sa croissance. La portion supérieure 54 comprend une base 57 dans laquelle les plans cristallographiques 58 sont perpendiculaires à l'axe Δ, une région intermédiaire 60, reposant sur la base 57 dans laquelle le matériau croît simultanément parallèlement à l'axe Δ et perpendiculairement à l'axe Δ, et une région périphérique 62, située autour de la base 57 et de la région intermédiaire 60, dans laquelle les plans cristallographiques 64 sont perpendiculaires à l'axe Δ. A titre d'exemple, dans le cas de fil 20 en GaN de polarité N, les plans cristallographiques 58 correspondent à des plans polaires -c, et les plans cristallographiques 64 correspondent à des plans cristallins (1-100), dits non polaires.

Selon un mode de réalisation, la base 57 est obtenue en adaptant les flux des gaz précurseurs de l'azote et de l'élément du groupe III pour favoriser la croissance privilégiée du fil 20 selon l'axe Δ. La région périphérique 62 est, par exemple, obtenue en réduisant la température de croissance à une valeur inférieure à environ 980°C préférentiellement inférieure à 950°C dans le cas de la croissance d'un matériau de type GaN ou GaAlN et à des températures inférieures à 750°C pour un matériau de type InGaN et en adaptant les flux des gaz précurseurs de l'azote et de l'élément du groupe III pour favoriser la croissance privilégiée du fil 20 perpendiculairement à l'axe Δ. La région intermédiaire 60 est obtenue en modifiant sans interruption les flux des gaz précurseurs de l'azote et de l'élément du groupe III depuis des valeurs qui sont favorables à la croissance privilégiée du fil 20 selon l'axe Δ jusqu'à des valeurs qui correspondent à celles utilisées pour favoriser la croissance de la couche intercalaire 30 du dispositif optoélectronique 10.

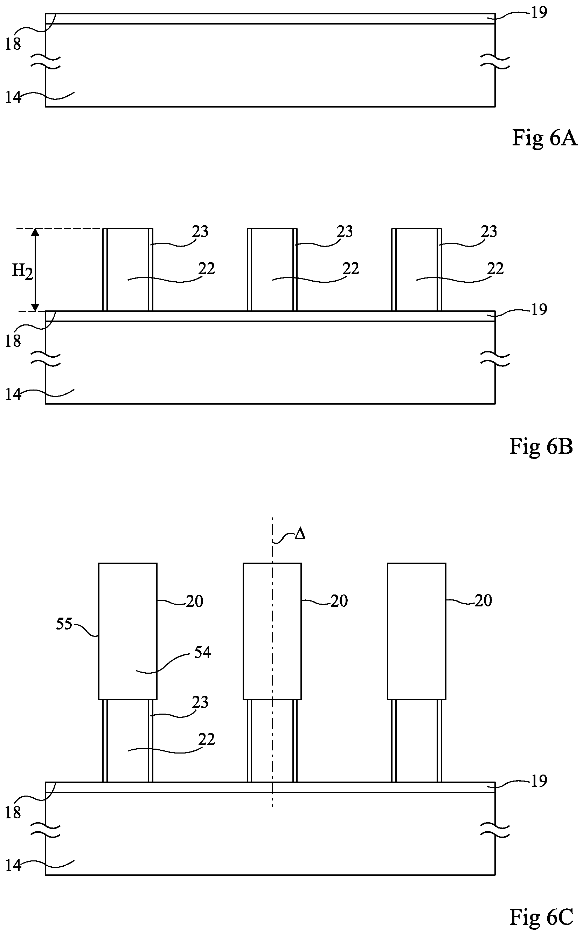

Les figures 6A à 6D sont des coupes, partielles et schématiques, des structures obtenues à des étapes successives d'un mode de réalisation d'un procédé de fabrication du dispositif optoélectronique 50 représenté en figure 4.

La figure 6A représente la structure obtenue après le traitement du substrat 14 pour favoriser la croissance de fils du composé III-V, par exemple du GaN à des emplacements privilégiés. Ce traitement est représenté de façon schématique par la formation de la couche de germination 19 en surface du substrat 14. L'étape de traitement peut ne pas être présente. Dans ce cas, les fils peuvent croître sur le substrat 14 de façon spontanée.

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V, tel que du GaN ou du GaAs, ou un substrat en ZnO. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouche de type silicium sur isolant, également appelée SOI (acronyme anglais pour Silicon On Insulator). Dans ce cas, l'électrode 12 peut être réalisée du côté de la face 18 du substrat 14. Le substrat 14 peut être fortement dopé, faiblement dopé ou non dopé.

Le traitement appliqué au substrat pour favoriser la croissance de fils peut correspondre à l'un des traitements décrits dans les documents US 7 829 443, FR 2 995 729 ou FR 2 997 558.

La figure 6B représente la structure obtenue après la croissance de la portion passivée 22 de chaque fil 20 sur la hauteur H₂ depuis la face 18 du substrat 14.

Les fils 20 sont, au moins en partie, formés à partir de matériaux semiconducteurs comportant majoritairement un composé III-V correspondant à un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlGaIn De façon générale, les éléments dans le composé III-N peuvent être combinés avec différentes fractions molaires.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément. Les fils 20 peuvent être de polarité azote ou de polarité gallium.

Les fils 20 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La hauteur H₁ de chaque fil 20 peut être comprise entre 250 nm et 50 µm. Chaque fil 20 peut avoir une structure semiconductrice allongée selon un axe sensiblement perpendiculaire à la face 18. Chaque fil 20 peut avoir une forme générale cylindrique (par exemple hexagonale). Les axes de deux fils 20 adjacents peuvent être distants de 0,5 µm à 10 µm et de préférence de 1,5 µm à 4 µm. A titre d'exemple, les fils 20 peuvent être régulièrement répartis, notamment selon un réseau hexagonal.

La section droite des fils 20 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 20 peut être compris entre 50 nm et 2,5 µm.

Le procédé de croissance des fils peut être un procédé du type dépôt chimique en phase vapeur organométallique (MOCVD, acronyme anglais pour Metal-Organic Chemical Vapor Deposition), également connu sous le nom d'épitaxie organométallique en phase vapeur (MOVPE, acronyme anglais pour Metal-Organic Vapor Phase Epitaxy).

Lorsque les fils sont majoritairement en un composé III-V, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphoshine (TBP), l'arsine (AsH₃) ou le diméthylhydrazine (UDMH).

Selon un mode de réalisation de l'invention, dans le cas de fil de polarité azote, dans la phase de croissance de la portion inférieure 22 du fil 20, un précurseur d'un élément supplémentaire est ajouté en excès en plus des précurseurs du composé III-V. L'élément supplémentaire peut être le silicium (Si). Un exemple de précurseur du silicium est le silane (SiH₄). La présence du précurseur de l'élément supplémentaire conduit à l'incorporation de l'élément supplémentaire dans le composé III-N pour doper ce composé III-N mais également à la formation de la couche 23 d'un matériau diélectrique principalement constitué de l'élément supplémentaire et d'azote sur les flancs latéraux des cristaux en croissance du composé III-N. La concentration de l'élément supplémentaire dans le composé III-V est comprise entre 10¹⁸ et 10²¹ atomes/cm³, par exemple de l'ordre de 10²⁰ atomes/cm³. La couche 23 du matériau diélectrique a une épaisseur comprise entre une monocouche atomique et 10 nm. Dans le cas où le composé III-N est du GaN et l'élément supplémentaire est du silicium, le GaN est fortement dopé de type N et sera appelé ici n⁺GaN et la couche 23 de matériau diélectrique est du nitrure de silicium SiN, de formule générale SiₓN_{y}, où x et y sont des nombres compris entre 1 et 4, par exemple sous forme stoechiométrique Si₃N₄.

A titre d'exemple, le procédé de fabrication décrit dans la demande de brevet WO2012136665 peut être mis en oeuvre. Dans le cas où la portion 22 est en n+GaN, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 1000°C et 1100°C, de préférence entre 1000°C et 1060°C. Pour transporter les espèces de la sortie des bulleurs aux deux plénums du réacteur, on utilise un flux de gaz porteur, par exemple du N₂, de 2000 sccm réparti dans les deux plénums.

La figure 6C représente la structure obtenue après la formation de la portion supérieure 54 de chaque fil 20 depuis le sommet de la portion inférieure 22.

Selon l'invention, lors de la croissance de la portion supérieure 54 du fil 20, les conditions de fonctionnement du réacteur MOCVD sont modifiées de façon continue ou de façon graduelle pour passer de conditions initiales favorisant la croissance du matériau composant la portion supérieure 54 selon l'axe Δ du fil 20, à des conditions finales favorisant la croissance du matériau composant la portion supérieure 54 perpendiculaire aux faces latérales 55 de la portion supérieure 54.

Selon un mode de réalisation, lors de la croissance de la portion supérieure 54 du fil 20, la température de croissance est abaissée de façon continue afin de passer de conditions favorables à la croissance selon l'axe Δ à des conditions favorables à la croissance perpendiculaire à l'axe Δ. Dans le cas de la croissance du matériau GaN ou GaAlN, la température initiale est supérieure à 1000°C et la température finale est inférieure à 950°C. Dans le cas de matériaux de type GaInN, la température initiale est supérieure à 1000°C et la température finale est inférieure à 730°C.

Selon un mode de réalisation, les conditions initiales peuvent être les conditions de fonctionnement du réacteur MOCVD décrites précédemment pour la formation des portions inférieures 22 à l'exception du fait que le flux de silane dans le réacteur est réduit, par exemple d'un facteur supérieur ou égal à 10, ou arrêté. Même lorsque le flux de silane est arrêté, une portion supérieure 54 peut être dopée de type N en raison de la diffusion dans cette portion de dopants provenant des portions passivées 22 adjacentes ou en raison du dopage résiduel du GaN.

Selon un mode de réalisation, le rapport entre le flux molaire de l'élément du groupe V et le flux molaire de l'élément du groupe III, ou rapport V/III, aux conditions initiales est inférieur ou égal à 300, de préférence inférieur ou égal à 200. Selon un mode de réalisation, le rapport V/III aux conditions finales est supérieur ou égal à 500, de préférence supérieur ou égal à 1000, plus préférentiellement supérieur ou égal à 5000.

Selon un mode de réalisation, la pression dans le réacteur aux conditions initiales est supérieure ou égale à 400 Torr (environ 53 kPa), de préférence supérieure ou égale à 500 Torr (environ 67 kPa). Selon un mode de réalisation, la pression dans le réacteur aux conditions finales est inférieure ou égale à 300 Torr (environ 40 kPa), de préférence supérieure ou égale à 200 Torr (environ 27 kPa).

Selon un mode de réalisation, le rapport entre le flux de H₂ et le flux de N₂, appelé rapport H₂/N₂, dans le réacteur aux conditions initiales est inférieur ou égal à 40/60, de préférence inférieur ou égal à 30/70. Selon un mode de réalisation, le rapport H₂/N₂ aux conditions finales est supérieur ou égal à 60/40, de préférence supérieur ou égal à 70/30.

Selon un mode de réalisation, au moins l'un des paramètres choisis parmi le rapport V/III, la pression dans le réacteur et le rapport H₂/N₂ est modifié de façon continue ou de façon graduelle pour passer des conditions initiales aux conditions finales. Selon un mode de réalisation, le rapport V/III, la pression dans le réacteur, et/ou le rapport H₂/N₂ peuvent chacun évoluer de façon linéaire entre les valeurs initiales et les valeurs finales.

A titre de variante, dans le cas où la zone active 31 comprend au moins une couche d'un matériau semiconducteur ternaire, comprenant, par exemple, en plus du composé III-V de la portion supérieure 54, un élément supplémentaire du groupe III, par exemple l'indium, un gaz précurseur de cet élément supplémentaire peut être introduit dans le réacteur au cours de la croissance de la portion supérieure 54.

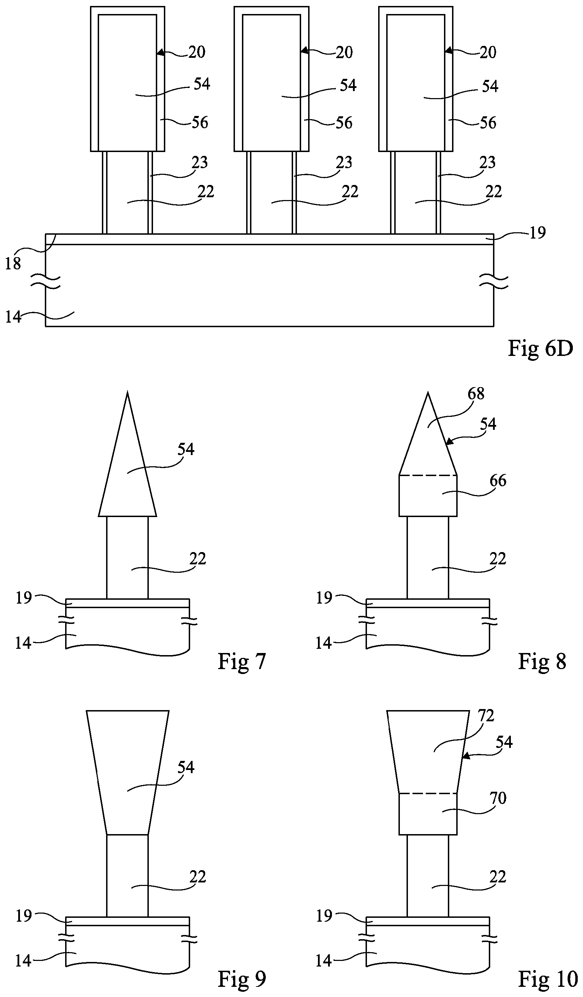

La figure 6D représente la structure obtenue après avoir formé par épitaxie les couches semiconductrices de la coque 56. Compte tenu de la présence de la couche passivante 23 sur la portion inférieure 22, le dépôt des couches semiconductrices de la coque 56 ne se produit que sur la portion supérieure 54.

Parmi les couches de la coque 56, la couche de blocage d'électrons 32 peut être formée d'un alliage ternaire, par exemple en nitrure de gallium et d'aluminium (AlGaN) ou en nitrure d'indium et d'aluminium (AlInN) en contact avec la zone active 31 et la couche intermédiaire 34, pour assurer une bonne répartition des porteurs électriques dans la zone active 31.

La couche intermédiaire 34, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure de type N du fil 20 de la jonction P-N ou P-I-N.

La couche de liaison 36 peut correspondre à une couche semiconductrice ou à un empilement de couches semiconductrices et permet la formation d'un contact ohmique entre la couche intermédiaire et l'électrode 29. A titre d'exemple, la couche de liaison peut être dopée très fortement du type opposé à la portion inférieure du fil 20, jusqu'à dégénérer la ou les couches semiconductrices, par exemple dopée de type P à une concentration supérieure ou égale à 10²⁰ atomes/cm³.

Les étapes finales du mode de réalisation du procédé de fabrication comprennent la formation des portions isolantes 28 et des électrodes 12 et 29. La portion isolante 28 peut être en un matériau diélectrique, par exemple en oxyde de silicium (SiO₂).

L'électrode 29 est adaptée à polariser la couche active de chaque fil 20 et à laisser passer le rayonnement électromagnétique émis par les diodes électroluminescentes DEL. Le matériau formant l'électrode 29 peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 29 a une épaisseur comprise entre 5 nm et 200 nm, de préférence entre 20 nm et 50 nm.

A titre de variante, une couche d'encapsulation, non représentée, recouvrant la couche d'électrode 29 peut être prévue. La couche d'encapsulation est réalisée en un matériau isolant et au moins partiellement transparent. La couche d'encapsulation peut être réalisée en un matériau inorganique transparent, par exemple un oxyde de silicium ou de l'oxyde d'aluminium, ou en un matériau organique au moins partiellement transparent, par exemple un polymère silicone, un polymère époxyde, un polymère acrylique ou un polycarbonate. A titre de variante, une couche conductrice miroir, non représentée, recouvrant la couche d'électrode 29 entre les fils 20 mais ne s'étendant pas sur les fils 20, peut être prévue. La couche conductrice miroir peut correspondre à une couche métallique, par exemple en aluminium, en argent, en cuivre ou en zinc. Selon une autre variante, le dispositif optoélectronique peut, en outre, comprendre une couche de luminophores, non représentée.

La façon dont le rapport V/III, la pression et/ou le rapport H₂/N₂ évolue entre les conditions initiales et les conditions finales détermine la forme extérieure de la portion supérieure 54 du fil 20.

Sur la figure 6C, la portion supérieure 54 de chaque fil 20 est représentée avec une forme sensiblement filaire.

Les figures 7 et 8 représentent d'autres modes de réalisation de la portion 54 dans le cas où la portion 54 a la polarité gallium.

Sur la figure 7, la portion supérieure 54 de chaque fil 20 a une forme conique.

Sur la figure 8, la portion supérieure 54 de chaque fil 20 comprend une première partie filaire 66 qui s'étend depuis le sommet de la portion inférieure 22 et qui se prolonge par une portion conique 68.

Les figures 9 et 10 représentent d'autres modes de réalisation de la portion 54 dans le cas où la portion 54 a la polarité azote.

Sur la figure 9, la portion supérieure 54 de chaque fil peut avoir une forme tronconique inversée.

Sur la figure 10, la portion supérieure 54 de chaque fil 20 comprend une première partie filaire 70 qui s'étend depuis le sommet de la portion inférieure 22 et qui se prolonge par une portion tronconique inversée 72.

## Revendications

1. Procédé de fabrication d'un dispositif optoélectronique (50) comprenant des éléments semiconducteurs (20) filaires, coniques ou tronconiques comportant majoritairement un composé III-V, chaque élément semiconducteur s'étendant selon un axe (Δ) et comprenant une portion (54) dont les faces latérales (55) sont recouvertes d'une coque (56) comprenant au moins une zone active (31), dans lequel l'élément du groupe V est l'azote, dans lequel un gaz précurseur de l'élément du groupe V et un gaz précurseur de l'élément du groupe III sont injectés dans un réacteur, dans lequel les portions sont réalisées par croissance continue dans le réacteur par dépôt chimique en phase vapeur organométallique en modifiant sans interruption les flux des gaz précurseurs de l'élément du groupe V et de l'élément du groupe III, et dans lequel la température dans le réacteur varie, au cours de la croissance continue des portions, sans interruption d'une première valeur de température supérieure à 1000°C qui favorise la croissance de premiers plans cristallographiques (58) perpendiculaires audit axe, à une deuxième valeur de température inférieure à 950°C, qui favorise la croissance de deuxièmes plans cristallographiques (64) parallèles audit axe.

2. Procédé selon la revendication 1, dans lequel la deuxième valeur de température est inférieure à 750°C.

3. Procédé selon la revendication 1 ou 2, dans lequel le rapport entre le flux du gaz précurseur de l'élément du groupe V et le flux du gaz précurseur de l'élément du groupe III, appelé rapport V/III, varie d'une première valeur de rapport V/III à une deuxième valeur de rapport V/III supérieure strictement à la première valeur de rapport V/III.

4. Procédé selon la revendication 3, dans lequel la première valeur de rapport V/III est inférieure à 300, de préférence inférieure à 200, et dans lequel la deuxième valeur de rapport V/III est supérieure à 500, de préférence supérieure à 1000.

5. Procédé selon l'une quelconque des revendications 1 à 4, dans lequel la pression dans le réacteur est amenée, au cours de la croissance continue des portions (54), d'une première valeur de pression à une deuxième valeur de pression inférieure strictement à la première valeur de pression.

6. Procédé selon la revendication 5, dans lequel la première valeur de pression est supérieure à 53 kPa, de préférence supérieure à 67 kPa, et dans lequel la deuxième valeur de pression est inférieure à 40 kPa, de préférence inférieure à 27 kPa.

7. Procédé selon l'une quelconque des revendications 1 à 6, dans lequel du dihydrogène et du diazote sont injectés dans le réacteur et dans lequel le rapport entre le flux de dihydrogène et le flux de diazote, appelé rapport H₂/N₂, varie d'une première valeur de rapport H₂/N₂ à une deuxième valeur de rapport H₂/N₂ supérieure strictement à la première valeur de rapport H₂/N₂.

8. Procédé selon la revendication 7, dans lequel la première valeur de rapport H₂/N₂ est inférieure à 40/60, de préférence inférieure à 30/70, et dans lequel la deuxième valeur de rapport H₂/N₂ est supérieure à 60/40, de préférence supérieure à 70/30.

9. Procédé selon l'une quelconque des revendications 1 à 8, dans lequel les zones actives (31) sont les zones depuis lesquelles est émise la majorité du rayonnement fourni par le dispositif optoélectronique (50) ou dans lesquelles est capturée la majorité du rayonnement reçu par le dispositif optoélectronique.

10. Procédé selon l'une quelconque des revendications 1 à 9, dans lequel le composé III-V est un composé III-N choisi parmi le groupe comprenant le nitrure de gallium, le nitrure d'aluminium, le nitrure d'indium, le nitrure de gallium et d'indium, le nitrure de gallium et d'aluminium, le nitrure d'aluminium et d'indium et le nitrure de gallium, d'aluminium et d'indium.

11. Procédé selon l'une quelconque des revendications 1 à 10, dans lequel la portion (54) a une composition uniforme.

## Patentansprüche

1. Ein Verfahren zum Herstellen einer optoelektronischen Einrichtung (50), die drahtförmige, konische oder kegelstumpfförmige Halbleiterelemente (20) aufweist, die hauptsächlich eine III-V-Verbindung aufweisen, wobei sich jedes Halbleiterelement entlang einer Achse (Δ) erstreckt und einen Abschnitt (54) aufweist, dessen Seitenflächen (55) mit einer Hülle (56) bedeckt sind, die wenigstens einen aktiven Bereich (31) aufweist, wobei das Element der Gruppe V Stickstoff ist, wobei ein Vorläufergas des Elements der Gruppe V und ein Vorläufergas des Elements der Gruppe III in den Reaktor injiziert werden, wobei die Abschnitte durch kontinuierliches Wachstum in dem Reaktor durch metallorganische chemische Gasphasenabscheidung ausgebildet werden, indem die Ströme der Vorläufergase des Elements der Gruppe V und des Elements der Gruppe III ohne Unterbrechung verändert werden, und wobei die Temperatur in dem Reaktor während des kontinuierlichen Wachstums der Abschnitte ohne Unterbrechung von einem ersten Temperaturwert von mehr als 1.000 °C, der das Wachstum erster kristallographischer Ebenen (58) senkrecht zu der genannten Achse fördert, zu einem zweiten Temperaturwert von weniger als 950 °C, der das Wachstum zweiter kristallographischer Ebenen (64) parallel zu der genannten Achse fördert, variiert.

2. Das Verfahren nach Anspruch 1, wobei der zweite Temperaturwert weniger als 750 °C beträgt.

3. Das Verfahren nach Anspruch 1 oder 2, wobei das Verhältnis des Stroms des Vorläufergases des Elements der Gruppe V zu dem Strom des Vorläufergases des Elements der Gruppe III, das als V/III-Verhältnis bezeichnet wird, von einem ersten Wert des V/III-Verhältnisses zu einem zweiten Wert des V/III-Verhältnisses variiert, der größer als der erste Wert des V/III-Verhältnisses ist.

4. Das Verfahren nach Anspruch 3, wobei der erste Wert des V/III-Verhältnisses kleiner als 300, vorzugsweise kleiner als 200, ist und wobei der zweite Wert des V/III-Verhältnisses größer als 500, vorzugsweise größer als 1.000, ist.

5. Das Verfahren nach einem der Ansprüche 1 bis 4, wobei der Druck in dem Reaktor während des kontinuierlichen Wachstums der Abschnitte (54) von einem ersten Druckwert auf einen zweiten Druckwert gebracht wird, der niedriger als der erste Druckwert ist.

6. Das Verfahren nach Anspruch 5, wobei der erste Druckwert höher als 53 kPa, vorzugsweise höher als 67 kPa, ist und wobei der zweite Druckwert niedriger als 40 kPa, vorzugsweise niedriger als 27 kPa, ist.

7. Das Verfahren nach einem der Ansprüche 1 bis 6, wobei Wasserstoff und Stickstoff in den Reaktor injiziert werden und wobei das Verhältnis des Wasserstoffstroms zu dem Stickstoffstrom, das als H₂/N₂-Verhältnis bezeichnet wird, von einem ersten Wert des H₂/N₂-Verhältnisses zu einem zweiten Wert des H₂/N₂-Verhältnisses variiert, der größer als der erste Wert des H₂/N₂-Verhältnisses ist.

8. Das Verfahren nach Anspruch 7, wobei der erste Wert des H₂/N₂-Verhältnisses kleiner als 40/60, vorzugsweise kleiner als 30/70, ist und wobei der zweite Wert des H₂/N₂-Verhältnisses größer als 60/40, vorzugsweise größer als 70/30, ist.

9. Das Verfahren nach einem der Ansprüche 1 bis 8, wobei die aktiven Bereiche (31) die Bereiche sind, von denen der größte Teil der von der optoelektronischen Einrichtung (50) bereitgestellten Strahlung emittiert wird oder in denen der größte Teil der von der optoelektronischen Einrichtung empfangenen Strahlung erfasst wird.

10. Das Verfahren nach einem der Ansprüche 1 bis 9, wobei die III-V-Verbindung eine III-N-Verbindung ist, die insbesondere aus der Gruppe ausgewählt ist, die Galliumnitrid, Aluminiumnitrid, Indiumnitrid, Galliumindiumnitrid, Galliumaluminiumnitrid, Aluminiumindiumnitrid und Galliumaluminiumindiumnitrid aufweist.

11. Das Verfahren nach einem der Ansprüche 1 bis 10, wobei der Abschnitt (54) eine einheitliche Zusammensetzung aufweist.

## Claims

1. A method of manufacturing an optoelectronic device (50) comprising wire-shaped, conical, or frustoconical semiconductor elements (20) mainly comprising a III-V compound, each semiconductor element extending along an axis (Δ) and comprising a portion (54) having its lateral surfaces (55) covered with a shell (56) comprising at least one active area (31), wherein the group-V element is nitrogen, wherein a precursor gas of the group-V element and a precursor gas of the group-III element are injected into the reactor, wherein the portions are formed by continuous growth in the reactor by metal-organic chemical vapor deposition by modifying with no interruption the flows of the precursor gases of the group-V element and of the group-III element, and wherein the temperature in the reactor varies, along the continuous growth of the portions, uninterruptedly from a first temperature value higher than 1,000°C which promotes the growth of first crystallographic planes (58) perpendicular to said axis to a second temperature value lower than 950°C, which promotes the growth of second crystallographic planes (64) parallel to said axis.

2. The method of claim 1, wherein the second temperature value is lower than 750°C.

3. The method of claim 1 or 2, wherein the ratio of the flow of precursor gas of the group-V element to the flow of precursor gas of the group-III element, called V/III ratio, varies from a first value of the V/III ratio to a second value of the V/III ratio greater than the first value of the V/III ratio.

4. The method of claim 3, wherein the first value of the V/III ratio is smaller than 300, preferably smaller than 200, and wherein the second value of the V/III ratio is greater than 500, preferably greater than 1,000.

5. The method of any of claims 1 to 4, wherein the pressure in the reactor is taken, along the continuous growth of the portions (54), from a first pressure value to a second pressure value lower than the first pressure value.

6. The method of claim 5, wherein the first pressure value is higher than 53 kPa, preferably higher than 67 kPa, and wherein the second pressure value is lower than 40 kPa, preferably lower than 27 kPa.

7. The method of any of claims 1 to 6, wherein hydrogen and nitrogen are injected into the reactor and wherein the ratio of the hydrogen flow to the nitrogen flow, called H₂/N₂ ratio, varies from a first value of the H₂/N₂ ratio to a second value of the H₂/N₂ ratio greater than the first value of the H₂/N₂ ratio.

8. The method of claim 7, wherein the first value of the H₂/N₂ ratio is smaller than 40/60, preferably smaller than 30/70, and wherein the second value of the H₂/N₂ ratio is greater than 60/40, preferably greater than 70/30.

9. The method of any of claims 1 to 8, wherein the active areas (31) are the areas having most the radiation supplied by the optoelectronic device (50) emitted therefrom or having most the radiation received by the optoelectronic device captured therein.

10. The method of any of claims 1 to 9, wherein the III-V compound is a III-N compound, particularly selected from the group comprising gallium nitride, aluminum nitride, indium nitride, gallium indium nitride, gallium aluminum nitride, aluminum indium nitride, and gallium aluminum indium nitride.

11. The method of any of claims 1 to 10, wherein the portion (54) has a uniform composition.
